**Europäisches Patentamt**

**European Patent Office**

**Office européen des brevets**

(19)

(11) Publication number : **0 417 735 B1**

## (12) EUROPEAN PATENT SPECIFICATION

(45) Date of publication of patent specification :
**15.02.95 Bulletin 95/07**

(51) Int. Cl.⁶ : **H03J 9/06**

(21) Application number : **90117497.9**

(22) Date of filing : **11.09.90**

(54) Improved television receiver.

(30) Priority : **11.09.89 IT 6775089**

(43) Date of publication of application :
**20.03.91 Bulletin 91/12**

(45) Publication of the grant of the patent :
**15.02.95 Bulletin 95/07**

(84) Designated Contracting States :
**CH DE ES FR GB IT LI NL**

(56) References cited :
**EP-A- 0 331 257**
**US-A- 4 698 617**
**ELECTRONIC ENGINEERING, vol. 55, no. 676,**
**April 1983, pages 41-43,47; G. TORELLI et al.:**
**"PCM remote control chips detect transmis-**
**sion errors"**

(73) Proprietor : **SOCIETA ITALIANA PER LO**
**SVILUPPO DELL'ELETTRONICA S.I.SV.EL**
**S.P.A.**
**Via Castagnole, 59**
**I-10060 None (TO) (IT)**

(72) Inventor : **Farina, Attilio**
**via Ventimiglia, 162**
**I-10127 Torino (IT)**

(74) Representative : **Konle, Tilmar, Dipl.-Ing.**
**Benderstrasse 23 a**
**D-81247 München (DE)**

## Description

It is known that the television sets located in public places or in hotels are normally of the type without remote control; this fact creates inconvenience for the user, particularly in hotel rooms where the client often watch TV lying on the bed.

The lack of the remote control is due to the fact that the transmitting device is considered as having high risk to be stealed.

In order to avoid the discomfort some basic controls, as the on-off-switch and volume, are sometimes available near the bed head causing, however, greater cost and reducing only in part the inconvenience.

From "Electronic Engineering", Vol. 55, No. 676, April 1983, pp. 41 to 43 and 47, it is known to avoid mutual interference in multiple remote control systems by transmitting each command with a pin-programmable 4-bit adress which identifies the transmitter.

It is further known from EP-A-0 331 257 to incorporate into a remote control transmitter a permanent non-erasable memory for storing formating data and commanding bit patterns for a plurality of devices of different categories manufactured by different manufacturers which are all controlled by the remote control transmitter.

The object of the present invention is to reduce the risk of stealing the remote control transmitter.

This object is solved by independent claims 1 and 2.

The invention is described in the following with reference to the drawing. In the drawing

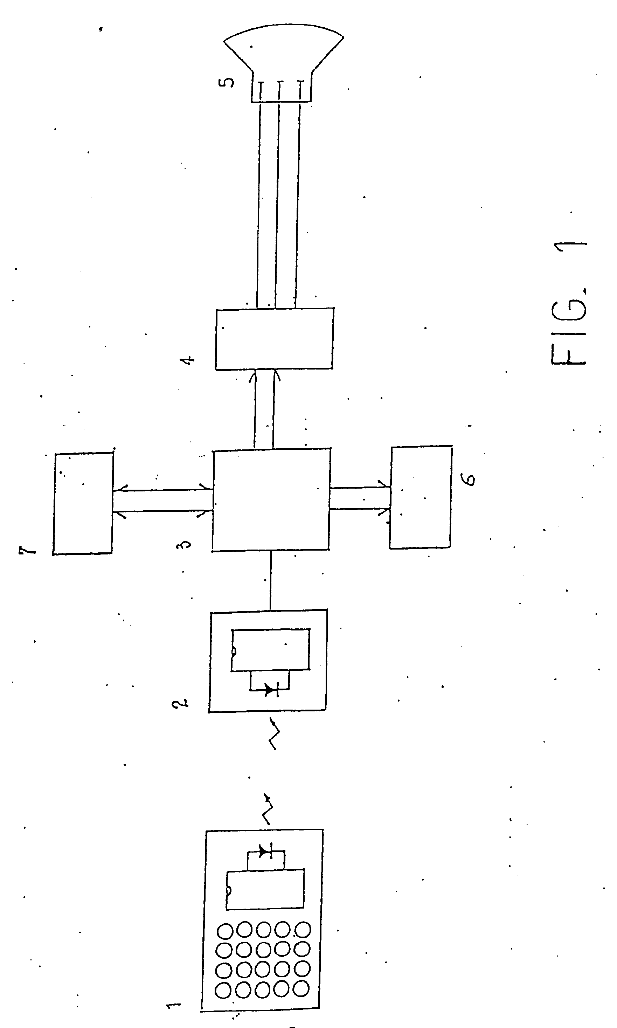

fig. 1    shows schematically the control codes cyphering and decyphering principle used in the television receiver according to the invention.

In fig. 1 which schematically shows the control codes cyphering and decyphering principle used in the television receiver according to the invention, the reference number 1 indicates a remote control transmitter, for instance of the infrared rays type, comprising a keyboard with a plurality of keys, for remote controlling the television receiver operation. Said transmitter, besides the control keyboard, comprises normally a dedicated integrated circuit and one or more infrared LED diodes. In the shown embodiment of the transmitting device there is also contained a EPROM memory with a binary number of 10 bits stored therein and a small logic circuit comprising an EXCLUSIVE-OR gate.

Reference number 2 indicates the corresponding receiver which provides for receiving and decoding the signals coming from device 1; the receiver comprises a phototransistor, sensitive to the infrared rays emitted by device 1, and an integrated circuit, which corresponds to the circuit contained in the transmitter, and which is able to decode the received commands.

With reference number 3 there is indicated a logic control unit, which in the relevant example comprises a microprocessor of a suitable type, for instance of the 8 or 16 bits type, normally used in television receivers; e.g. a Z80 or a MC68000.

Said microprocessor is connected to a memory (indicated with reference number 6), which contains the operating instructions for the control unit; memory 6 may advantageously be of the ROM type (a dead, non-alterable, i.e. a read only memory); the control unit 3 is also connected to another memory 7, of the EPROM type, equal to that contained in the device 1, and containing the same 10 bits word.

With reference number 4 there is indicated a decoding and video amplifying circuit, of a known type, for a colour television set; said circuit 4 shows three outputs, connected to a colour picture display device (indicated with reference number 5), represented in the relevant case by a known type shadow mask tube.

Codes cyphering in the transmitting device 1 is made by means of a key number, which is different for each individual transmitter-receiver, contained in the said EPROM memory.

In order to obtain the cyphering, the normal code, corresponding to the command to be transmitted, is combined, in the EXOR gate, with the key word; the so cyphered code is then transmitted, received by device 2 and sent to unit 3; the latter provides for decyphering, performing an EXOR operation with the key word, contained in EPROM 7, and then for sending the relevant decyphered code to normal operating means of the TV receiver.

Let's show an example: let's assume that the command to be transmitted is the command for tuning into channel 1; and that said command corresponds, for the transmitting device 1, to binary code 1011101100.

Said code, EXOR combined with the key word, which we assume, in the relevant case, to be 1110001110 yields as resulting code 0101100010.

This is now then the code which is transmitted by transmitter 1 to receiver 2. In a normal TV set, using the same commercially available remote control devices, said code does not correspond to the command 'tune into channel 1', but to another command, for instance to the command 'increase the volume'. transmitter 1 cannot therefore operate together any TV receiver but the very one which has been coupled to it in the factory, containing the proper EPROM 7. Only in said receiver in fact the received code 0101100010 is EXOR combined with the key word 1110001110 yielding the original code 1011101100.

In fact:

1011101100 EXOR    0101100010

EXOR

1110001110  =      1110001110  =

0101100010         1011101100

It is clear from the above demonstration that the improved TV receiver according to the invention creates the possibility to provide a television set in a public place, for instance in a hotel room, with a remote control avoiding any risk of theft, which will on the contrary be very high using normal remote control devices.

It is obvious that, keeping in mind the invention principle, there are several possible changes which may be made to the characteristics of the improved television receiver which has been described as a way of example, without departing from the novelty scope of the present invention.

In the described example in the receiver a microprocessor has been used to perform the EXOR operation, as in all modern television receivers a microprocessor is already provided in order to perform control operations, and therefore this appears to be the cheapest solution; nevertheless it is clear that the EXOR operation may be easily performed also without the need of a microprocessor, but using, as provided in the transmitter, a wired logic circuit.

The key word, which does not need to be changed, may be stored, both in the transmitter and in the receiver, without using an EPROM, but for instance using a wired fixed logic circuit.

Another possible variation is that to use, in the receiver, a non-volatile RAM memory; in this case there is the advantage that in case the transmitter gets lost or breaks down, the key word of the receiver may be changed to match that of a new transmitter; this may be done providing for a suitable procedure, of known type, suitably protected, so that the receiver can receive from the transmitter the new word and memorize it.

## Claims

1. Use of an exclusive cyphering and decyphering of coded command signals which are transmitted between each individual transmitter-receiver pair (1/2) from a plurality of television receivers (2) and remote control transmitters (1), for preventing the theft of said transmitters (1), said cyphering and decyphering being performed by individual key words each memorized in the transmitter and in the receiver of each individual transmitter-receiver pair (1/2), the decyphering being carried out by an exclusive decyphering circuit (3,7).

2. A plurality of television receivers, each of them comprising a control unit (3) for processing a coded command signal being transmitted from a related remote control transmitter (1), said control unit (3) identifying only those command signals whose coding corresponds to the coding of the related receiver (2), wherein an exclusive coupling of each individual transmitter (1) from said plurality of transmitters with only one individual receiver (2) from a plurality of related receivers is provided for preventing the theft of said transmitters (1) by exclusive cyphering of said coding, said cyphering being made by means of an individual key word which is different for each individual transmitter-receiver pair (1/2), each receiver (2) comprising an exclusive decyphering circuit (3, 7) capable of decyphering said cyphered control code received from said individually coupled remote control transmitter (1), said key-word being memorized both in the transmitter (1) and in the receiver (2) of each individual transmitter-receiver pair (1/2) so that an individual transmitter (1) can operate only and exclusively together with its individually coupled receiver (2).

## Patentansprüche

1. Verwendung einer exklusiven Verschlüsselung und Entschlüsselung von codierten Befehlssignalen, welche zwischen jedem individuellen Sender-Empfänger-Paar (1/2) einer Vielzahl von Fernsehempfängern (2) und von Fernsteuerungssendern (1) übetragen werden, um den Diebstahl der Sender (1) zu verhindern, wobei die Verschlüsselung und Entschlüsselung mit Hilfe individueller Schlüsselworte erfolgt, von denen jedes in dem Sender und in dem Empfänger jedes individuellen Sender-Empfänger-Paares (1/2) gespeichert wird, und wobei die Entschlüsselung mittels einer exklusiven Entschlüsselungsschaltung durchgeführt wird.

2. Vielzahl von Fernsehempfängern, von denen jeder eine Steuereinheit (3) zur Verarbeitung eines codierten Befehlssignals aufweist, welches von einem zugeordneten Fernsteuersender (1) übertragen wird, wobei die Steuereinheit (3) nur solche Befehlssignale identifiziert, deren Codierung der Codierung des zugeordneten Empfängers (2) entspricht, wobei eine exklusive Kopplung jedes individuellen Senders (1) der Vielzahl von Empfängern mit nur einem individuellen Empfänger (2) der Vielzahl von zugeordneten Empfängern vorgesehen ist, um den Diebstahl der Sender (1) durch exklusive Verschlüsselung der Codierung zu verhindern, wobei die Verschlüsselung mit Hilfe eines individuellen Schlüsselwortes erfolgt, welches für jedes individuelle Sender-Empfänger-Paar (1/2) unterschiedlich ist, wobei jeder Empfänger (2) eine exklusive Entschlüsselungsschaltung (3,7) aufweist, welche in der Lage ist, den verschlüsselten, von dem individuell gekoppelten Fernsteuersender (1) empfangenen Steuercode zu entschlüsseln, wobei das Schlüsselwort sowohl in dem Sender (1) als auch in dem Empfänger (2) jedes individuellen Sender-Empfänger-Paares (1/2) gespeichert ist, derart, daß ein individueller Sender (1) nur und ausschließlich zusammen mit seinem individuell gekoppelten Empfänger zusammen funktionieren kann.

## Revendications

1. Une utilisation d'un chiffrage et d'un déchiffrage exclusifs de signaux de commande codés qui sont transmis entre chaque paire individuelle d'émetteur-récepteur (1/2) d'une pluralité de récepteurs de télévision (2) et d'émetteurs de télécommande (1), pour empêcher le vol desdits émetteurs (1), lesdits chiffrage et déchiffrage étant effectués par des mots individuels de clé de chiffrage mémorisés chacun dans l'émetteur et dans le récepteur de chaque paire individuelle d'émetteur-récepteur (1/2), le déchiffrage étant effectué par un circuit de déchiffrage exclusif (3, 7).

2. Une pluralité de récepteurs de télévision, comprenant chacun d'eux une unité de commande (3) pour traiter un signal de commande codé qui est transmis par un émetteur de télécommande associé (1), ladite unité de commande (3) identifiant uniquement les signaux de commande dont le codage correspond au codage du récepteur associé (2), dans lesquels est prévu un couplage exclusif de chaque émetteur individuel (1) de ladite pluralité d'émetteurs avec seulement un récepteur individuel (2) parmi une pluralité de récepteurs associés afin d'empêcher le vol desdits émetteurs (1) par un chiffrage exclusif dudit codage, ledit chiffrage étant réalisé au moyen d'un mot individuel de clé de chiffrage qui est différent pour chaque paire individuelle d'émetteur-récepteur (1/2), chaque récepteur (2) comprenant un circuit de déchiffrage exclusif (3, 7) capable de déchiffrer ledit code de commande chiffré reçu en provenance dudit émetteur de télécommande couplé individuellement (1), ledit mot de clé de chiffrage étant mémorisé à la fois dans l'émetteur (1) et dans le récepteur (2) de chaque paire individuelle d'émetteur-récepteur (1/2), si bien qu'un émetteur individuel (1) peut fonctionner conjointement uniquement et exclusivement avec son récepteur couplé individuellement (2).

FIG. 1

EP 0 417 735 B1